# EUROPÄISCHE PATENTSCHRIFT

(11) **EP 0 720 748 B1**
(45) Veröffentlichungstag und Bekanntmachung des Hinweises auf die Patenterteilung: **18.11.1998**
(21) Anmeldenummer: 94926800.7
(22) Anmeldetag: 20.09.1994
(51) Int. Cl.: G01P 15/08

(54) **INTEGRIERTE MIKROMECHANISCHE SENSORVORRICHTUNG UND VERFAHREN ZU DEREN HERSTELLUNG**
INTEGRATED MICROMECHANICAL SENSOR DEVICE AND PROCESS FOR PRODUCING IT
DISPOSITIF DE DETECTION MICROMECANIQUE INTEGRE ET SON PROCEDE DE PRODUCTION

(30) Priorität: 21.09.1993 DE 4332057
(43) Veröffentlichungstag der Anmeldung: 10.07.1996
(73) Patentinhaber: SIEMENS AKTIENGESELLSCHAFT, 80333 München (DE)
(72) Erfinder: WERNER, Wolfgang Dr., D-81545 München (DE)
(86) Internationale Anmeldenummer: DE9401092
(87) Internationale Veröffentlichungsnummer: WO9508775

(56) Entgegenhaltungen:
- EP-A- 0 591 554
- EP-A- 0 605 300
- WO-A-92/03740

## Beschreibung

Die Erfindung betrifft eine integrierte mikromechanische Sensorvorrichtung und ein Verfahren zu ihrer Herstellung.

Mikromechanische Sensoren finden zunehmend Eingang in alle Bereiche der Technik, z. B. in Navigationssysteme und Kraftfahrzeuge, insbesondere in Verbindung mit Sicherheitssystemen. Einen großen Teil derartiger Sensoren bilden Druck- und Beschleunigungssensoren. Gefragt sind zuverlässige, kleine, einfach herzustellende und dabei preiswerte Sensoren mit einer hohen Meßgenauigkeit und einer guten Proportionalität zwischen Meßgröße und Ausgangssignal.

Die meisten heute verwendeten Druck- oder Beschleunigungssensoren werden feinmechanisch oder mittels KOH-Ätztechnik auf Siliziumbasis (bulk-micromachining) hergestellt. Die Auswertung des bislang meist mittels des Piezoeffekts erzeugten Sensorsignals erfolgt getrennt vom Sensor. Der Trend geht jedoch zum intelligenten Sensor, bei dem der Sensor sowie die Schaltung zur Auswertung des Sensorsignals und gegebenenfalls eine Testschaltung auf Basis der Siliziumplanartechnologie auf einem Chip integriert sind. Die Auswertung des piezoresistiven oder kapazitiven Sensorsignals sowie die Linearisierung und Verstärkung erfolgen mit Halbleiterschaltkreisen bekannter Technologien. Ein derartiger Sensor ist beispielsweise aus der Veröffentlichung F. Goodenough: Airbags Boom When IC Accelerometer Sees 50 G, Electronic Design, August 8, 1991, pp. 45-56 bekannt.

Während konventionell hergestellte mikromechanische Sensoren relativ groß, teuer und ungenau sind, beschreibt die vorstehend genannte Veröffentlichung eine verbesserte Ausführungsform. Dieser bekannte sogenannte oberflächen-mikromechanische Sensor (surface micromachining) benötigt, wie insbesondere aus der diesbezüglichen weiteren Veröffentlichung: Analog Devices Combines Micromachining and BICMOS, Semiconductor International, Okt. 1991 hervorgeht, zu seiner Herstellung 21 Masken, nämlich 6 Masken für den Sensorprozeß und 15 Masken für einen 4 µm-BICMOS-Prozeß. Das zur Ausbildung des kapazitiven Sensors kammförmige Sensorelement besteht aus einem 2µm-dicken Polysiliziumelement und ist über Federn, die ebenfalls aus Polysilizium sind, mit der Substratoberfläche verbunden.

Das Herstellverfahren für den bekannten Sensor ist außerordentlich aufwendig und teuer. Darüberhinaus ist unsicher, ob die für die mechanisch bewegten Teile des Sensors verwendeten Polysiliziumschichten eine ausreichende mechanische Langzeitstabilität aufweisen. Neben dieser möglichen zeitlichen Degradation sind die mechanischen Eigenschaften wie der Elastizitätsmodul oder intrinsischer Streß von Polysilizium sensibel von den jeweiligen Prozeßbedingungen während der Herstellung abhängig. Die thermische Ausheilung des intrinsischen Stresses erfordert im Herstellungsprozeß zusätzliche Temperschritte, was sich nachteilig auf die gleichzeitig in dem Sensor integrierte elektronische Schaltung auswirkt. Zudem sind im Herstellungsprozeß zusätzliche Abscheidungen von Halbleiterschichten notwendig. Bei einem denkbaren Einsatz von modernen Sub-µm-BICMOS-Schaltungen für die Auswerteschaltung des Sensors ist es aufgrund der dabei verwendeten niedrigen Prozeßtemperaturen nicht mehr möglich, streßfreie Polysiliziumschichten herzustellen.

Die nachveröffentlichte DE-A-43 09 917 beschreibt die Verwendung einer einkristallinen Siliziumschicht mit einer darüberliegenden Siliziumnitridschicht.

Die Erfindung sieht eine integrierte mikromechanische Sensorvorrichtung vor,bei der ein Körper mit einem Substrat, mit einer darüber angeordneten einkristallinen Siliziumschicht und mit einer in einem vorgegebenen Bereich dazwischen angeordneten isolierenden Schicht gebildet ist,
bei der die Siliziumschicht Gräben von ihrer Oberfläche bis zu ihrer unteren Grenzfläche aufweist,
bei der in der Siliziumschicht die Seitenwände der Gräben und die der unteren Grenzfläche der Siliziumschicht zugeordnete Zone der Siliziumschicht eine erste vorgegebene Dotierung haben und die Siliziumschicht zumindest in einem Teilbereich eine zweite vorgegebene Dotierung aufweist,
bei der eine Transistoranordnung in einem ersten Bereich der Siliziumschicht über der isolierenden Schicht vorgesehen ist und
bei der eine Sensoranordnung in einem zweiten Bereich der Siliziumschicht vorgesehen ist, in dem zumindest teilweise keine isolierende Schicht vorhanden ist.

Ein Verfahren zur Herstellung einer integrierten mikromechanischen Sensorvorrichtung sieht folgende Schritte vor:
- Bilden eines Grundkörpers mit einer auf einem Substrat angeordneten isolierenden Schicht und einer darüber angeordneten einkristallinen Siliziumschicht, wobei die Siliziumschicht eine vorgegebene Dotierung aufweist,
- Ätzen von Gräben in der Siliziumschicht bis auf die Oberfläche der isolierenden Schicht,
- Dotieren der Grabenwände,
- Erzeugen einer Transistoranordnung in einem ersten Bereich der Siliziumschicht und
- Entfernen der isolierenden Schicht unter einem zweiten Bereich der Siliziumschicht.

Nach dem Dotieren der Grabenwände können die Gräben mit einer isolierenden Oxidschicht aufgefüllt werden. Vorzugsweise werden die Gräben jedoch nach ihrer Herstellung mit einem dotierenden Oxid (dotierende Isolierschicht) aufgefüllt, das als Dotierquelle für die nachfolgende Dotierung der Grabenwände dient. Das Oxid in den Gräben wird unter dem zweiten Bereich der Siliziumschicht in Verbindung mit der isolierenden Schicht wieder entfernt.

Der gemäß der Erfindung hergestellte Sensor enthält einkristallines Silizium. Er vermeidet die Verwendung von Polysiliziumschichten für die mechanisch bewegten Teile, da für diese Teile einkristallines Silizium verwendet wird. Einkristallines Silizium besitzt genau bekannte mechanische Eigenschaften, die nicht von den jeweiligen Parametern des Herstellungsprozesses abhängen. Zudem sind die mechanischen Eigenschaften keiner zeitlichen Degradation unterworfen, so daß die Langzeitstabilität sehr groß ist.

Die Erfindung hat den weiteren Vorteil, daß sie unter Verwendung bekannter und verfügbarer Grabenätz- und Auffüllverfahren in vollem Umfang VLSI-kompatibel ist. Weiterhin ist die erfindungsgemäße Sensorvorrichtung mechanisch robust, da sich die beweglichen Teile in der Siliziumschicht befinden und nicht auf der Chipoberfläche. Da die Elektroden des Sensors senkrecht zur Chipoberfläche stehen ergibt sich eine hohe spezifische Kapazität (Packungsdichte) des Sensors. Gleichzeitig wird das Sticking-Problem, d. h. eine Adhäsion von Flächen beim oder nach einem Spülvorgang entschärft, da die Steifigkeit der Sensorvorrichtung senkrecht zur Schwingungsrichtung sehr groß ist.

Schließlich bietet die erfindungsgemäße Sensorvorrichtung den erheblichen Vorteil, daß bei der Verwendung eines bipolaren oder eines BICMOS-Prozesses die Maskenzahl zur Herstellung der Sensorvorrichtung gegenüber einem Standardprozeß in diesen Technologien nicht erhöht wird.

Ausgestaltungen der Erfindung sind in Unteransprüchen gekennzeichnet.

Die Erfindung wird nachfolgend anhand von Figuren der Zeichnung näher erläutert, von denen
- Figuren 1 bis 5: Querschnitte durch eine erfindungsgemäße Vorrichtung bei verschiedenen Herstellverfahrensschritten zeigen und
- Figur 6: eine Draufsicht auf eine kapazitive Sensoranordnung zeigt.

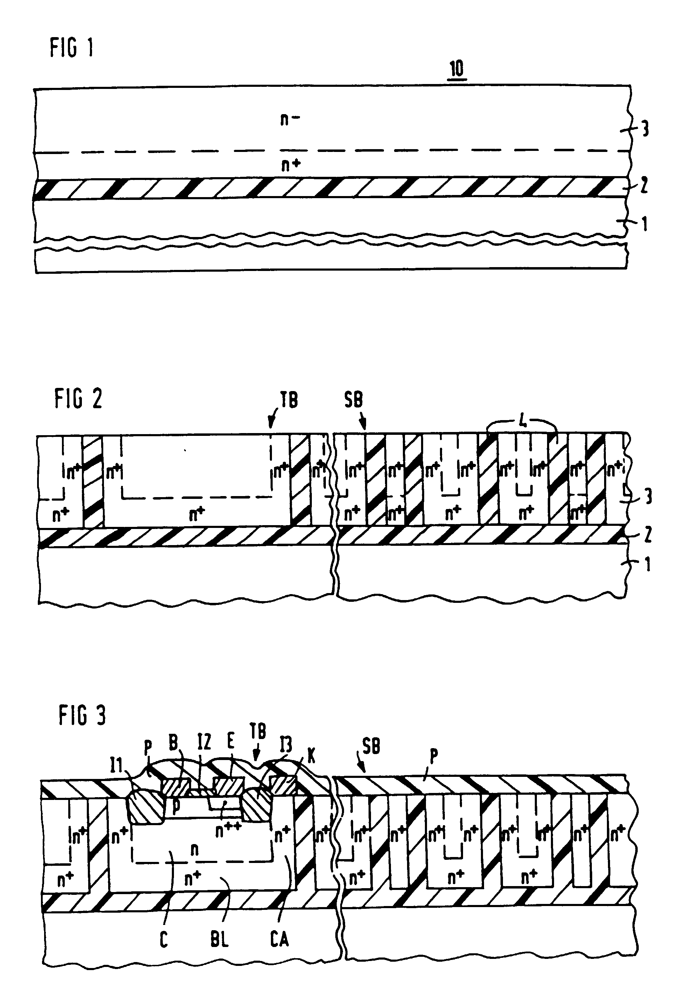

Figur 1 zeigt einen bei der Herstellung der integrierten mikromechanischen Sensorvorrichtung gebildeten Grundkörper 10. Auf einem Substrat 1 ist eine isolierende Schicht 2 und auf dieser isolierenden Schicht eine einkristalline Siliziumschicht 3 angeordnet. Das Substrat kann ebenfalls aus Silizium bestehen. Typischerweise wird die Dicke der isolierenden Schicht 2 zwischen 0,5 und 1 um gewählt, während die Schichtdicke der Siliziumschicht 3 z. B. zwischen 5 und 20 um betragen kann. Die Kristallorientierung und Dotierung des Substrats ist beliebig. Die Orientierung und Dotierung der Siliziumschicht 3 entspricht der bei der Herstellung der Sensorvorrichtung und deren Halbleiterschaltungsanordnung verwendeten Basistechnologie.

Im Ausführungsbeispiel gemäß Figur 1 ist die der isolierenden Schicht 2 bzw. die der unteren Granzfläche der Siliziumschicht zugewandte Seite der Siliziumschicht 3 n⁺-dotiert, während die von der isolierenden Schicht 2 abgewandte Oberflächenzone der Siliziumschicht n⁻-dotiert ist. Die Dotierung der Siliziumschicht 3 ist für das eigentliche Sensorelement nicht notwendig, sondern richtet sich ausschließlich nach der Technologie, die für die integrierte Schaltungsanordnung verwendet werden soll.

Der Grundkörper gemäß Figur 1 kann z. B. eine DWB-Scheibe sein, wobei DWB Direct-Wafer-Bonding bedeutet. Derartige Scheiben sind aus zwei Halbleiterscheiben zusammengeklebt und lassen sich mit hoher Qualität mit den in Figur 1 gezeigten Schichtdicken und Dotierungen am Markt erwerben. Eine weitere Möglichkeit zur Herstellung des in Figur 1 gezeigten Grundkörpers ist die Verwendung des sogenannten SIMOX-Verfahrens (I. Ruge, H. Mader: Halbleiter-Technologie, Springer-Verlag, 3. Auflage, 1991, Seite 237). Dabei wird eine isolierende Schicht aus Siliziumoxid durch tiefe Ionenimplantation von Sauerstoffatomen in einkristallines Silizium gebildet. Daran kann sich ein Epitaxieschritt anschließen. Eine dritte Möglichkeit zur Herstellung des Grundkörpers gemäß Figur 1 macht von der Rekristallisation Gebrauch, bei der eine über einer einkristallinen Siliziumschicht und einer darauf angeordneten Siliziumoxidschicht zunächst amorph oder polykristallin abgeschiedene Siliziumschicht durch Aufschmelzen mit einem Laserstrahl rekristallisiert wird.

In einem nächsten Schritt werden in die einkristalline Siliziumschicht 3 Gräben bis auf die Oberfläche der isolierenden Schicht 2 geätzt, beispielsweise durch eine anisotrope Trockenätzung. Anschließend werden die Gräben mit einem dotierenden Isolierstoff aufgefüllt. Im Ausführungsbeispiel gemäß Figur 2 kann Phosphorglas (PSG) oder Borphosphorglas (BPSG) verwendet werden. Die Erzeugung derartiger Glasschichten ist beispielsweise aus D. Widmann, H. Mader, H. Friedrich: Technologie hochintegrierter Schaltungen, Springer-Verlag, 1988, Seite 80 ff. bekannt. Bei einer entsprechenden Temperaturbehandlung diffundieren Phosphor und gegebenenfalls Bor aus dem Phosphorglas in das Silizium der Grabenwände der Siliziumschicht 3 ein. Damit ergibt sich die in Figur 2 gezeigte Struktur, bei der die isolierende Schicht 2 und die dotierende Isolierschicht 4 am Fuß der zuvor geätzten Gräben aufeinanderstoßen. Die Grabenwände sind entsprechend der an der isolierenden Schicht 2 angrenzenden Zone der Siliziumschicht 3 dotiert, d. h. im Ausführungsbeispiel n⁺-dotiert.

Durch das Ätzen von Gräben in der Siliziumschicht und das Dotieren der Grabenwände werden sowohl der Bereich SB, in dem der eigentliche Sensor vorgesehen ist, als auch der Bereich TB, in dem die elektronische Auswerteschaltung, zumindest aber eine Transistoranordnung für die Verarbeitung des Sensorsignals vorgesehen ist, strukturiert und gegeneinander isoliert. Der Bereich TB beinhaltet eine oder mehrere isolierte Wannen, in die je nach Vorgabe CMOS-, Bipolar- oder sonstige Bauelemente eingebaut werden. Wenn die im Bereich TB zu realisierende Transistoranordnung z. B. ein bipolarer Transistor ist, ist mit der in Figur 2 gezeigten Struktur des Bereichs TB bereits eine vergrabene Kollektorzone und ein niederohmiger Kollektor-Anschluß in Form der dotierten Grabenwände erzeugt. Gegenüber Anordnungen aus dem Stand der Technik erfordert die Erzeugung der in Figur 2 gezeigten Struktur keine separaten Masken- und Dotierungsprozesse für die vergrabene Zone, für einen Kanalstopper und für einen Kollektor. Ein Epitaxieprozeß kann ebenfalls entfallen.

Ausgehend von der Struktur der Figur 2 wird anschließend eine Transistoranordnung in dem Bereich TB erzeugt. Diese Transistoranordnung kann mit einem standardmäßigen bipolaren oder BICMOS-Prozeß hergestellt werden. Beispiel für derartige Prozesse sind z. B. aus der vorgenannten Veröffentlichung Widmann/Mader/Friedrich: Technologie hochintegrierter Schaltungen bekannt. Bei einer bipolaren Transistorstruktur kann z. B., ausgehend von Figur 2, zunächst die Basiszone, bei einem BICMOS-Prozeß zunächst die p-bzw. n-Wanne erzeugt werden.

Selbstverständlich ist es möglich, ausgehend von der Struktur der Figur 2 auch eine MOS-Transistoranordnung in dem Grundkörper zu realisieren. Auch in diesem Fall beginnt der standardmäßige Prozeß mit der Erzeugung einer p- bzw. n-Wanne in dem für die Transistorstrukturen vorgesehenen Bereich TB.

Während der Erzeugung der Transistoranordnung wird der Bereich SB, der für das Sensorelement vorgesehen ist, durch eine entsprechende Maske abgedeckt. Gemäß Figur 3 ergibt sich z. B. ein bipolarer Transistor, dessen Kollektor C niederohmig über die vergrabene Zone BL und die hochdotierten niederohmigen Grabenwände CA mit dem Kollektoranschluß K verbunden sind. Die p-dotierte Basis ist mit dem Basisanschluß B verbunden. Entsprechend ist der Emitteranschluß E über der hochdotierten n⁺⁺-Zone angeordnet. Basis-, Emitter- und Kollektorbereiche des Transistors sind über Isolationszonen I1 bis I3, vorzugsweise aus Siliziumoxid SiO₂, gegeneinander isoliert. Anschließend wird über der gesamten Anordnung eine Passivierungsschicht P aufgebracht. Beispielsweise kann die Passivierungsschicht aus Siliziumnitrid Si₃N₄ bestehen.

Im Anschluß an die Erzeugung der Transistoranordnung wird die Passivierungsschicht P über dem Sensorbereich SB mit Hilfe einer Lackmaske FM entfernt und danach zunächst der dotierende Isolierstoff 4 in den Gräben des Sensorbereichs und danach die isolierende Schicht 2 zumindest in Teilzonen des Sensorbereichs SB entfernt. Dies kann z. B. durch einen naßchemischen oder einen Trocken-Ätzprozeß erfolgen. Die isolierende Schicht 2 wird dabei unter den beweglichen Elektroden des Sensorelements vollständig und unter den nicht beweglichen Elektroden des Sensorelements nicht vollständig entfernt, so daß letztere weiterhin mechanisch mit dem Substrat 1 verbunden sind.

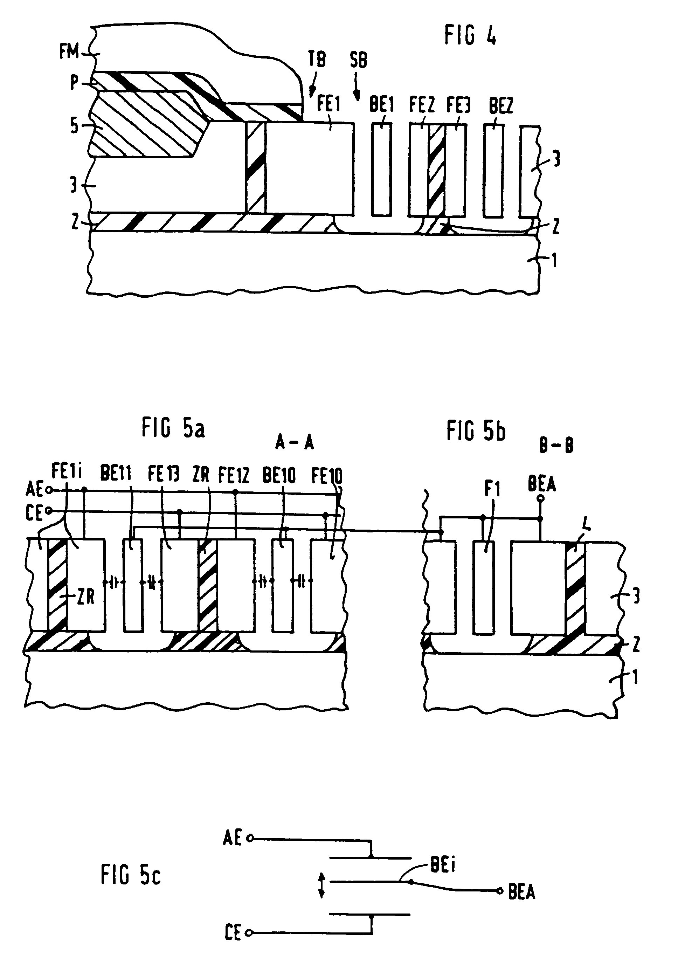

Figur 4 zeigt eine Anordnung nach dem Entfernen des Isolierstoffs 4 und der isolierenden Schicht 2 neben und unter den beweglichen Elektroden BE1, BE2 des Sensorbereichs SB, während unter den festen Elektroden FE1, FE2 und FE3 die isolierende Schicht 2 noch teilweise vorhanden ist. In der Anordnung gemäß Figur 4 ist der Transistorbereich TB anders als in Figur 3 strukturiert. Während sich an den Dotierungsverhältnissen der Siliziumschicht 3 in der Anordnung der Figur 4 gegenüber der Figur 2 nichts verändert hat, ist im Transistorbereich der Figur 4 zum Rand des Sensorbereichs hin eine Oxidschicht 5 vorgesehen. Der Transistorbereich ist mit einer Passivierungsschicht P und einer über dieser liegenden Lackmaske FM abgedeckt.

Um ein möglicherweise bei der Entfernung der isolierenden Schicht 2 unter dem Bereich der beweglichen Elektroden BEi auftretendes Adhäsionsproblem (Sticking) zu lösen, können sublimierende Chemikalien, z. B. Cyclohexan oder Dichlorbenzol verwendet werden.

Im Anschluß an das geschilderte Entfernen der isolierenden Schicht wird die Maske FM entfernt.

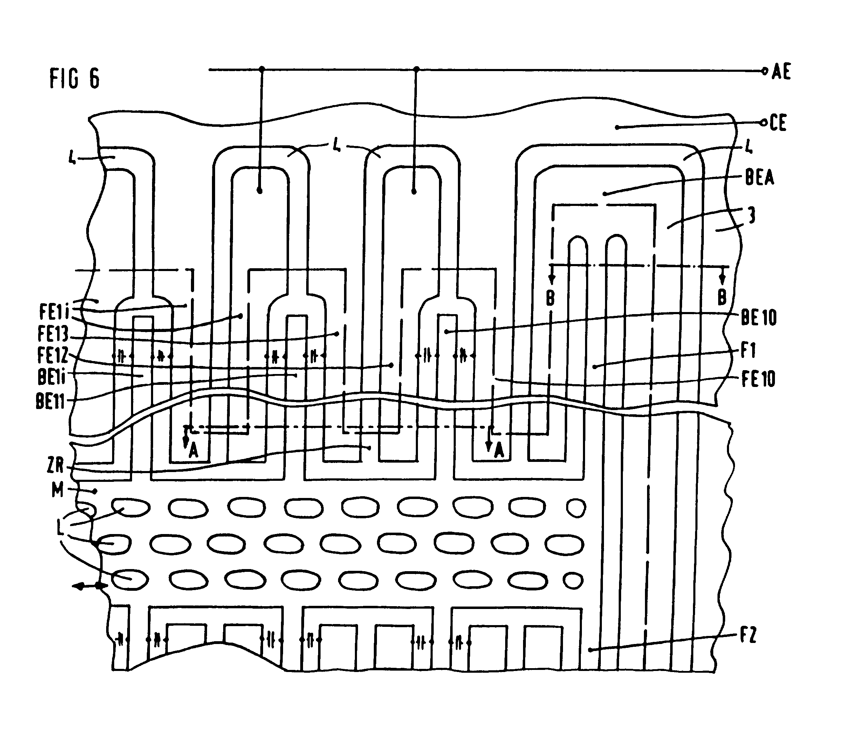

Figur 5 zeigt Querschnitte durch eine Sensorstruktur, die in Figur 6 in Draufsicht dargestellt ist. Es handelt sich um einen Beschleunigungssensor, der ein bewegliches Masseteil M hat, das über Federelemente F1, F2 und weitere nicht dargestellte Federelemente an der Siliziumschicht 3 aufgehängt ist. Das Masseteil M hat fingerförmige bewegliche Elektroden BE10, BE11 und BE1i, die frei in Bereiche zwischen festen Elektroden FE10 bis FE13 sowie FEli, hineinragen. Zwischen den beweglichen Elektroden BEi und den festen Elektroden FEi sind, da die Grabenwände der Elektroden hochdotiert sind, Kapazitäten gebildet, die in Figur 6 und in Figur 5a rein symbolisch dargestellt sind. Figur 5a zeigt dabei einen Schnitt entlang der Linie A-A und Figur 5b einen Schnitt entlang der Linie B-B, die in Figur 6 eingezeichnet sind. Um bei der Herstellung des Sensorteils die isolierende Schicht unter dem Masseteil zuverlässig entfernen zu können, enthält das Masseteil M Löcher L. Grundsätzlich sind die Löcher jedoch nicht zwingend erforderlich. In Figur 6 ist der Bereich der Sondermaske, die für die Erzeugung der Sensorstrukturen verwendet wird, skizziert. Innerhalb des durch die Sondermaske SM definierten Bereichs erfolgt das Entfernen des dotierenden Isolierstoffs aus den Gräben und der isolierenden Schicht neben und unterhalb der beweglichen Elektroden, des Masseteils und der Federn vollständig.

Figur 5c zeigt das mit der Sensorstruktur von Figur 5a und b bzw. Figur 6 erhaltene Ersatzschaltbild. Die beweglichen Elektroden BEi, d.h. BE10i bis BE1i sind über das Masseteil M und die Feder Fi mit einem Anschluß BEA verbindbar. Die festen Elektroden sind paarweise mit Anschlüssen AE und CE verbunden, die den festen Platten eines Kondensators entsprechen. Die beweglichen Elektroden bilden eine bewegliche Platte des Kondensators, so daß Figur 5c einen Differentialkondensator darstellt.

Aus den Zwischenräumen ZR zwischen zwei festen Elektroden, Figur 5a, kann der dotierende Isolierstoff entfernt werden. Es ist jedoch auch möglich, daß die Zwischenräume ZR der festen Elektroden und die darunterliegende isolierende Schicht, die den jeweiligen festen Elektroden zugewandt ist, erhalten bleiben. Voraussetzung ist eine andere Maske, mit der sich nur die isolierende Schicht und der dotierende Isolierstoff unterhalb und zwischen den beweglichen Elektroden entfernen lassen.

Die festen Elektroden können alternativ zu der Struktur von Figur 5 bzw. Figur 6 in ähnlicher Weise wie in der zuvor zitierten Veröffentlichung Electronic Design mit dem Substrat 1 bzw. der isolierenden Schicht 2 mechanisch verbunden sein. Die Befestigung über einen Anker hat freitragende Elektroden zur Konsequenz, was bedeutet, daß die festen Elektroden hinsichtlich auf sie wirkender Beschleunigungskräfte ausreichend biegesteif sein müssen, damit zusätzliche Meßfehler nicht negativ auf die Meßgenauigkeit wirken.

Die in Figur 6 dargestellte Sensoranordnung reagiert sensibel auf Bewegungen des Masseteils in der angedeuteten Pfeilrichtung. Die zulässige Auslenkung der fingerförmigen kapazitiven beweglichen Elektroden beträgt weniger als der Spaltabstand zu einer festen Elektrode, d. h. weniger als etwa 1µm. Vorzugsweise ist deshalb die Auswerteschaltung der Sensorvorrichtung als Regelkreis derart ausgestaltet, daß eine Regelspannung einer Auslenkung des Masseteils in dem Sinne entgegenwirkt, daß die durch den Differentialkondensator gebildeten Teilkapazitäten jeweils gleich sind. Dieses Verfahren hat den Vorteil, daß es ein Nullpunktverfahren ist und deshalb in der Regel genauer ist als ein absolutes Verfahren zur Bestimmung der Kapazitätsänderungen.

Eine zweidimensionale Beschleunigungsmessung ist möglich, wenn zwei Sensoranordnungen gemäß Figur 5 bzw. Figur 6 verwendet werden, die zueinander um 90°versetzt sind. Die Schwingungsrichtung der jeweiligen Masseteile liegt dabei in der Schwingungsrichtung der Chipebene in zwei zueinander senkrechten Richtungen. Die beschriebene Technik läßt sich in ähnlicher Weise auf die Herstellung von Differenzdrucksensoren anwenden.

Die Erfindung hat folgende Vorteile:

Das Sensormasseteil, die Elektroden und der Biegebalken, d. h. die Aufhängefedern des Sensors bestehen aus Monosilizium, so daß für die beweglichen Teile die von Polysilizium her bekannten Verbiegungen und Spannungen entfallen.

Masseteil des Sensors und die Federkonstante des Biegebalkens sowie bei einem kapazitiven Sensor die Sensorkapazität sind unabhängig voneinander einstellbar, so daß sich gut Sensorarrays realisieren lassen. Die Sensoranordnung erlaubt eine hohe Packungsdichte des Sensors, da die Elektroden senkrecht zur Chipoberfläche stehen, so daß sich eine große kapazitive Fläche erzielen läßt. Die Steifigkeit der Elektroden senkrecht zur Schwingungsrichtung ist sehr groß, da das Widerstandsmoment proportional zur 3. Potenz der Elektrodendicke ist. Aus diesem Grund tritt gegebenenfalls kein Adhäsions- bzw. Stickingproblem auf, so daß gegenwirkende Chemikalien nicht erforderlich sind.

Da sich die beweglichen Teile des Sensors im Silizium bzw. in der Siliziumschicht befinden und nicht auf der Chipoberfläche ist der Sensor mechanisch außerordentlich robust. Durch die Anordnung der Elektroden und des Masseteils in der Chipebene ist außerdem automatisch eine Überlastsicherung in der Chipebene gegeben.

Bei Verwendung eines bipolaren oder eines BICMOS-Standardprozesses als Basistechnologie für die Auswerteschaltung des intelligenten Sensors wird die Maskenzahl nicht erhöht. Dadurch lassen sich erhebliche Kosten sparen und der Herstellungsprozeß insgesamt vereinfachen.

Grundsätzlich ist das erfindungsgemäße Verfahren bzw. die Sensorvorrichtung kombinierbar mit allen bekannten Technologien. Insbesondere ist die Sensorvorrichtung VLSI-kompatibel, so daß Strukturbreiten unter 1µm erzielt werden können. Verwendung bei der Herstellung können deshalb die aus der Halbleitertechnologie bekannten Grabenätz- und Auffüllverfahren sowie die üblichen Halbleiterverfahren finden.

## Patentansprüche

1. Verfahren zur Herstellung einer integrierten mikromechanischen Sensorvorrichtung, **gekennzeichnet** durch folgende Schritte:
a) Bilden eines Körpers mit einer auf einem Substrat (1) angeordneten isolierenden Schicht (2) und einer darüber angeordneten einkristallinen Siliziumschicht (3), wobei die Siliziumschicht eine vorgegebene Dotierung (n⁺, n⁻) aufweist,
b) Ätzen von Gräben in der Siliziumschicht bis auf die Oberfläche der isolierenden Schicht,
c) Dotieren der Grabenwände,
d) Erzeugen einer Transistoranordnung in einem ersten Bereich (TB) der Siliziumschicht, und
e) Entfernen der isolierenden Schicht (2) unter einem zweiten Bereich (SB) der Siliziumschicht.

2. Verfahren nach Anspruch 1,
**dadurch gekennzeichnet,**
daß bei der Siliziumschicht an ihrer der isolierenden Schicht zugewandten Seite eine erste vorgegebene Dotierung (n⁺) und in ihrer Oberflächenzone eine zweite vorgegebene Dotierung (n⁻) vorgesehen werden.

3. Verfahren nach Anspruch 1 oder 2,
**dadurch gekennzeichnet,**
daß die Gräben nach Schritt b) mit einem dotierenden Isolierstoff (4) aufgefüllt und vor Schritt e) in dem zweiten Bereich (SB) freigelegt werden.

4. Verfahren nach einem der vorhergehenden Ansprüche,
**dadurch gekennzeichnet,**
daß die Gräben nach Schritt b) mit Phosphorglas aufgefüllt und vor Schritt e) in dem zweiten Bereich (SB) freigelegt werden.

5. Verfahren nach einem der vorhergehenden Ansprüche,
**dadurch gekennzeichnet,**
daß die Grabenwände entsprechend der ersten vorgegebenen Dotierung (n⁺) der Siliziumschicht (3) dotiert werden.

6. Verfahren nach einem der vorhergehenden Ansprüche,
**dadurch gekennzeichnet,**
daß die Transistoranordnung nach einem bipolaren, einem MOS- oder einem Bipolar-/MOS-Standardprozeß erzeugt wird.

7. Verfahren nach einem der vorhergehenden Ansprüche,
**dadurch gekennzeichnet,**
daß nach Erzeugen der Transistoranordnung eine Passivierungsschicht (P) in einem Sensorbereich (SB) entfernt und danach der Isolierstoff in den Gräben des Sensorbereichs und die isolierende Schicht unter der Siliziumschicht entfernt werden.

8. Integrierte mikromechanische Sensorvorrichtung,
bei der ein Körper (10) mit einem Substrat (1), mit einer darüber angeordneten einkristallinen Siliziumschicht (3) und mit einer in einem vorgegebenen Bereich dazwischen angeordneten isolierenden Schicht (2) gebildet ist,
bei der die Siliziumschicht Gräben von ihrer Oberfläche bis zu ihrer unteren Grenzfläche aufweist,
bei der in der Siliziumschicht (3) die Seitenwände der Gräben und die der unteren Grenzfläche der Siliziumschicht zugeordnete Seite der Siliziumschicht eine erste vorgegebene Dotierung (n⁺) haben und die Siliziumschicht zumindest in einem Teilbereich eine zweite vorgegebene Dotierung (n⁻) aufweist,
bei der eine Transistoranordnung in einem ersten Bereich (TB) der Siliziumschicht über der isolierenden Schicht (2) vorgesehen ist und
bei der eine Sensoranordnung in einem zweiten Bereich (SB) der Siliziumschicht vorgesehen ist, in dem zumindest teilweise keine isolierende Schicht vorhanden ist.

9. Vorrichtung nach Anspruch 8,
**dadurch gekennzeichnet,**
daß die Gräben in dem ersten Bereich mit einem Isolierstoff (4) aufgefüllt sind.

10. Vorrichtung nach Anspruch 8 oder 9,
**dadurch gekennzeichnet**,
daß als Transistoranordnung eine bipolare, eine MOS- oder eine Bipolar-MOS-Anordnung vorgesehen ist.

11. Vorrichtung nach einem der Ansprüche 8 bis 10,
**dadurch gekennzeichnet,**
daß die Sensoranordnung an zumindest einer Feder (F1) aufgehängt ist.

12. Vorrichtung nach einem der Ansprüche 8 bis 11,
**dadurch gekennzeichnet,**
daß die Sensoranordnung als kapazitiver oder piezoresistiver Sensor ausgebildet ist.

## Claims

1. Process for the production of an integrated micromechanical sensor device, characterized by the following steps:
a) forming a body with an insulating layer (2) arranged on a substrate (1), and a monocrystalline silicon layer (3) arranged thereon, the silicon layer having a predetermined doping type (n⁺, n⁻),
b) etching trenches in the silicon layer as far as the surface of the insulating layer,
c) doping the trench walls,
d) producing a transistor arrangement in a first region (TB) of the silicon layer, and
e) removing the insulating layer (2) under a second region (SB) of the silicon layer.

2. Process according to Claim 1, characterized in that, in the silicon layer, a first predetermined doping type (n⁺) is provided at its side adjacent to the insulating layer, and a second predetermined doping type (n⁻) is provided in its surface region.

3. Process according to Claim 1 or 2, characterized in that the trenches are filled with a doping insulant (4) after step b) and exposed in the second region (SB) before step e).

4. Process according to one the preceding claims, characterized in that the trenches are filled with phosphorus glass after step b) and exposed in the second region (SB) before step e).

5. Process according to one of the preceding claims, characterized in that the trench walls are doped in correspondence with the first predetermined doping type (n⁺) of the silicon layer (3).

6. Process according to one of the preceding claims, characterized in that the transistor arrangement is produced using a bipolar, MOS or bipolar/MOS standard process.

7. Process according to one of the preceding claims, characterized in that, after production of the transistor arrangement, a passivation layer (P) in a sensor region (SB) is removed, and thereafter the insulant in the trenches of the sensor region, as well as the insulating layer under the silicon layer, are removed.

8. Integrated micromechanical sensor device, in which a body (10) is formed with a substrate (1), with a monocrystalline silicon layer (3) arranged thereon and with an insulating layer (2) arranged in a predetermined region between the two, in which the silicon layer has trenches from its surface to its lower boundary, in which, in the silicon layer (3), the side walls of the trenches and the side of the silicon layer associated with the lower boundary of the silicon layer have a first predetermined doping type (n⁺), and the silicon layer has a second predetermined doping type (n⁻) at least in a partial region, in which a transistor arrangement is provided in a first region (TB) of the silicon layer, above the insulating layer (2), and in which a sensor arrangement is provided in a second region (SB) of the silicon layer, in at least some of which no insulating layer is present.

9. Device according to Claim 8, characterized in that the trenches in the first region are filled with an insulant (4).

10. Device according to Claim 8 or 9, characterized in that a bipolar, MOS or bipolar/MOS arrangement is provided as the transistor arrangement.

11. Device according to one of Claims 8 to 10, characterized in that the sensor arrangement is suspended from at least one spring (F1).

12. Device according to one of Claims 8 to 11, characterized in that the sensor arrangement is designed as a capacitive or piezoresistive sensor.

## Revendications

1. Procédé pour fabriquer un dispositif capteur micromécanique intégré, caractérisé par les étapes suivantes :
a) on forme un élément par une couche (2) isolante disposée sur un substrat (1) et par une couche (3) en silicium monocristalline disposée sur la première couche, la couche en silicium ayant un dopage (n⁺, n⁻) prescrit,
b) on ménage par attaque chimique des sillons dans la couche en silicium jusqu'à la surface de la couche isolante,
c) on dope les parois des sillons,
d) on produit un montage de transistor dans une première zone (TB) de la couche en silicium, et
e) on enlève la couche (2) isolante au-dessous d'une deuxième zone (SB) de la couche en silicium.

2. Procédé suivant la revendication 1, caractérisé en ce que l'on prévoit pour la couche en silicium, de son côté tourné vers la couche isolante, un premier dopage (n⁺) prescrit et, dans sa zone de surface, un deuxième dopage (n⁻) prescrit.

3. Procédé suivant la revendication 1 ou 2, caractérisé en ce que l'on remplit les sillons d'une matière (4) isolante dopante après l'étape b) et on les dégage dans la deuxième zone (SB) après l'étape e).

4. Procédé suivant l'une des revendications précédentes, caractérisé en ce que l'on remplit les sillons de verre au phosphosilicate après l'étape b) et on les dégage dans la deuxième zone (SB) après l'étape e).

5. Procédé suivant l'une des revendications précédentes, caractérisé en ce que l'on dope les parois de sillons suivant le premier dopage (n⁺) prescrit de la couche (3) en silicium.

6. Procédé suivant l'une des revendications précédentes, caractérisé en ce que l'on produit le montage de transistor suivant un processus normalisé bipolaire, MOS ou bipolaire/MOS.

7. Procédé suivant l'une des revendications précédentes, caractérisé en ce que, après avoir produit le montage de transistor, on enlève une couche (P) de passivation dans une zone (SB) de capteur et, ensuite on enlève la matière isolante dans les sillons de la zone de capteur et la couche isolante au-dessous de la couche en silicium.

8. Dispositif capteur micromécanique intégré, dans lequel un élément (10) est formé par un substrat (1), par une couche (3) en silicium monocristalline disposée sur le substrat et par une couche (2) isolante montée entre les deux dans une région prescrite, dans lequel la couche en silicium comporte des sillons de sa face supérieure jusqu'à sa face limite inférieure, dans lequel, dans la couche (3) en silicium, les parois latérales des sillons et le côté de la couche en silicium associés à la face limite inférieure de la couche en silicium ont un premier dopage (n⁺) prescrit et la couche en silicium a, au moins dans une zone partielle, un deuxième dopage (n⁻) prescrit, dans lequel un montage de transistor est prévu dans une première zone (TB) de la couche en silicium, au-dessus de la couche (2) isolante et dans lequel un montage capteur est prévu dans une deuxième zone (SB) de la couche en silicium dans laquelle il n'est pas présent, au moins sur une partie, de couche isolante.

9. Dispositif suivant la revendication 8, caractérisé en ce que les sillons ménagés dans la première zone sont remplis d'une matière (4) isolante.

10. Dispositif suivant la revendication 8 ou 9, caractérisé en ce qu'il est prévu comme montage de transistor un montage bipolaire, un montage MOS ou un montage bipolaire-MOS.

11. Dispositif suivant l'une des revendications 8 à 10, caractérisé en ce que le montage capteur est suspendu à au moins un ressort (F1).

12. Dispositif suivant l'une des revendications 8 à 11, caractérisé en ce que le montage capteur est réalisé en capteur capacitif ou piézo-résistif.
